Europäisches Patentamt

European Patent Office

Office européen des brevets

(11) Veröffentlichungsnummer: **0 319 737**
**A1**

## (12) EUROPÄISCHE PATENTANMELDUNG

(21) Anmeldenummer: 88118900.5

(51) Int. Cl.⁴: **G01R 33/06**

(22) Anmeldetag: **12.11.88**

(30) Priorität: **19.11.87 DE 3739111**

(43) Veröffentlichungstag der Anmeldung:
**14.06.89 Patentblatt 89/24**

(84) Benannte Vertragsstaaten:
**AT CH DE FR GB LI SE**

(71) Anmelder: **Standard Elektrik Lorenz Aktiengesellschaft
Lorenzstrasse 10
D-7000 Stuttgart 40(DE)**

(84) **DE**

Anmelder: **ALCATEL N.V.
Strawinskylaan 341 (World Trade Center)
NL-1077 XX Amsterdam(NL)**

(84) **CH FR GB LI SE AT**

(72) Erfinder: **Löwel, Helmut
Preysingstrasse 6
D-8500 Nürnberg 50(DE)**

(74) Vertreter: **Hösch, Günther, Dipl.-Ing. et al
Standard Elektrik Lorenz AG Patent- und
Lizenzwesen Postfach 30 09 29
D-7000 Stuttgart 30(DE)**

(54) **Magnetfelddetektor, Verfahren und Schaltungsanordnung zur Erzeugung eines elektrischen Signals mit dem Magnetfelddetektor.**

(57) Es wird ein Magnetfelddetektor angegeben, bei dem ein Magnetfeld einen als Magnetfeld-Sensor verwendeten magnetfeldabhängigen Widerstand (6) durchsetzt. Das Magnetfeld ist als Wechselmagnetfeld ausgebildet. Hierdurch sind Meßverfahren möglich, bei denen Änderungen des Widerstandswertes des magnetfeldabhängigen Widerstandes (6) über längere Zeitabschnitte, z.B. durch Temperatur und/oder Alterung, nicht in das Meßergebnis eingehen. Zwei Meßverfahren und eine jeweils zugehörige Schaltung werden beschrieben.

Fig.1

EP 0 319 737 A1

## Magnetfelddetektor, Verfahren und Schaltungsanordnung zur Erzeugung eines elektrischen Signals mit dem Magnetfelddetektor.

Die vorliegende Erfindung bezieht sich auf einen Magnetfelddetektor sowie Verfahren und Schaltungsanordnungen zur Erzeugung eines elektrischen Signals mit dem Magnetfelddetektor.

Derartige Magnetfelddetektoren, Verfahren und dabei verwendete mögliche Schaltungsanordnungen sind aus der Zeitschrift "eee", 1986, Nr. 16 vom 19.08.1986, Elektronik-Applikation, S. 43 bis 46 und der Zeitschrift "Elektronik", 1985, Heft 10, vom 17.05.1985, S. 99 bis 102 bekannt. Die verwendeten magnetfeldabhängigen Widerstände ändern ihren Wert maximal um etwa 2 %. In dieser Größenordnung liegen jedoch auch die Widerstandsänderungen, die durch Alterung und Temperaturänderung auftreten. Aus diesem Grund kommt vor allem der Temperaturkompensation große Bedeutung zu, wie besonders aus "Elektronik", S. 100, li.Sp. Abs. 5 bis S. 101, li.Sp. Abs. 5 hervorgeht.

Mit der vorgeschlagenen Lösung soll das technische Problem gelöst werden, einen Magnetfelddetektor sowie ein Verfahren und eine Schaltungsanordnung zur Erzeugung eines elektrischen Signals mit dem Magnetfelddetektor zu schaffen, welche die Eigenschaft aufweisen, daß eine durch Temperatur, Alterung oder mechanische Spannungen verursachte Widerstandsänderung des magnetfeldabhängigen Widerstandes im Magnetfelddetektor keinen Einfluß auf das elektrische Signal hat.

Gelöst wird diese Aufgabe durch die im Kennzeichen des Anspruchs 1 sowie der in den Ansprüchen 6, 11 und 12 angegebenen Maßnahmen. Durch die Verwendung eines Wechselmagnetfeldes wird erreicht, daß -unabhängig davon, ob das Magnetfeld vorhanden ist oder nicht- der Widerstandswert des magnetfeldabhängigen Widerstandes konstant bleibt, wenn dem magnetfeldabhängigen Widerstand ein ferromagnetisches Teil, z.B. ein zahnförmiges Weicheisenteil, oder eine Lücke zwischen zwei zahnförmigen Weicheisenteilen, gegenübersteht. Bei Annäherung der Kante eines ferromagnetischen Teiles an den magnetfeldabhängigen Widerstand tritt jedoch bei vorhandenem Magnetfeld eine Widerstandsänderung auf, die bei nicht vorhandenem Magnetfeld wieder verschwindet, d.h. in diesem Fall erhält man eine periodische Änderung des Widerstandswertes des magnetfeldabhängigen Widerstandes. Diese Änderung tritt immer auf, gleichgültig ob sich der Widerstandswert infolge Temperatur und oder Alterung ändert. Eine Betriebs- und oder Auswerteschaltung benötigt daher keinerlei besondere Maßnahmen zur Kompensation der genannten Widerstandsänderungen durch Temperatur und/oder Alterung, da nur noch das Vorhandensein oder nicht Vorhandensein eines Wechselsignals ermittelt werden muß. Dieses kann am magnetfeldabhängigen Widerstand unmittelbar als Wechselspannung abgenommen werden, beispielsweise wenn dieser Teil eines Spannungsteilers ist.

Weitere vorteilhafte Einzelheiten der Erfindung sind in den Unteransprüchen angegeben und nachfolgend anhand der in der Zeichnung veranschaulichten Ausführungsbeispiele beschrieben. Es zeigen:

Fig. 1 einen Magnetfelddetektor mit Elektromagnet und diesem gegenüberstehenden ferromagnetischen Teilen mit eine ferromagnetische Ablenkung bewirkenden Kanten,

Fig. 2 bis 4 je eine schematische Darstellung der Stellung eines ferromagnetischen Teils zum magnetfeldabhängigen Widerstand und die dabei auftretende Feldlinienverteilung,

Fig. 3a ein zu Fig. 3 gehöriges mögliches Impulsdiagramm,

Fig. 5 die Prinzipskizze eines Magnetfelddetektors mit einem permanentmagnetischen Polrad und

Fig. 6 und 7 je eine mögliche Schaltungsanordnung zur Ausübung von Verfahren unter Anwendung des Magnetfelddetektors.

Mit 1 ist ein Elektromagnet, bestehend aus einer auf einem Spulenkörper 2 aufgebrachten Wicklung 3 und einem ferromagnetischen Kern 4 bezeichnet. An der Polfläche 5 des Kerns 4 liegt, elektrisch von dieser isoliert, ein magnetfeldabhängiger Widerstand 6 an. Der Querschnitt des Kerns 4 ist an die Fläche des magnetfeldabhängigen Widerstandes 6 angepaßt. Die magnetische Vorzugsrichtung des magnetfeldabhängigen Widerstandes 6 ist wie üblich so gewählt, daß sich sein Widerstandswert bei einem ihn senkrecht durchsetzenden Magnetfeld nicht ändert.

Der Elektromagnet 1 ist in ein schachtelförmiges Gehäuse einsetzbar. Ebenso ist der magnetfeldabhängige Widerstand 6 mit seinem Träger 8 in das Gehäuse 7 einsetzbar, wozu die eine Seitenwand 9 innen eine die Wandstärke vermindernde Ausnehmung 10 in Form einer flachen Nut aufweist. Stege 11 im Gehäuse 7 dienen zur Lagefixierung des eingesetzten Elektromagneten 1.

Nach dem Einsetzen des Elektromagneten 1 werden im Gehäuse 7 seitlich vom Elektromagneten 1 Taschen 12 gebildet, in die eine elektrische Schaltung 13, z.B. eine gedruckte Schaltung, insbesondere in Dickschichttechnik, einsteckbar ist. Das Gehäuse wird anschließend zweckmäßigerweise mit Gießmasse ausgegossen, so daß eine stabile Baueinheit des Magnetfelddetektors mit einer integrierten Signalerzeugungsschaltung entsteht.

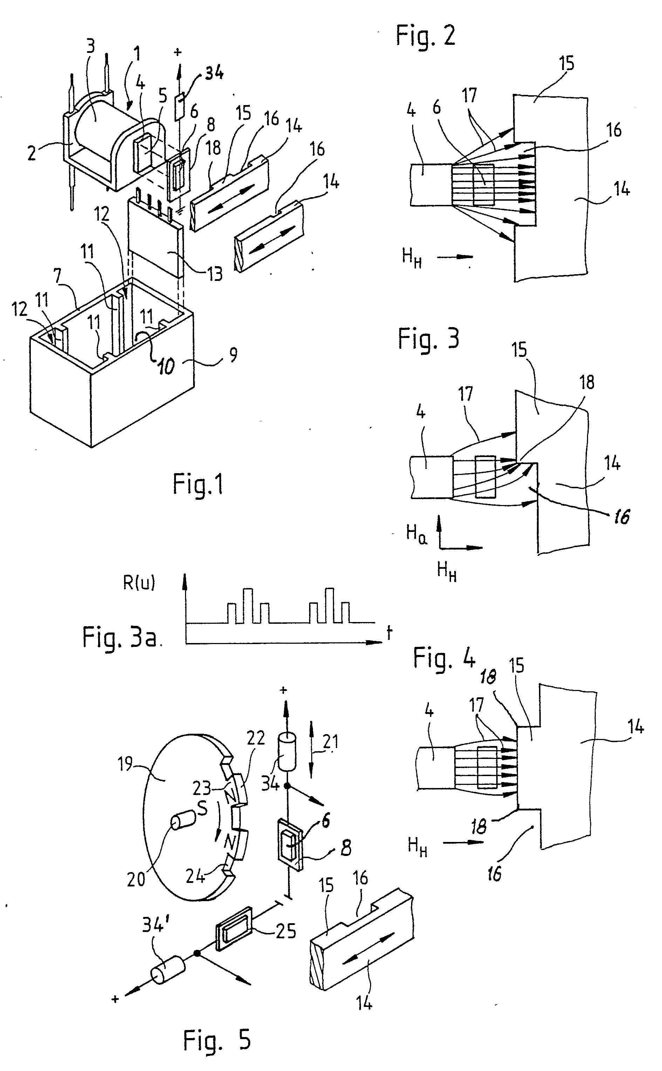

Vor der Seitenwand 9 können mit Zähnen 15 und Lücken 16 oder einer einzigen Lücke 16 versehene ferromagnetische Teile 14 in der Höhe des magnetfeldabhängigen Widerstandes 6 am Magnetfelddetektor vorbeibewegt werden. Die dabei auftretenden Richtungsänderungen der magnetischen Feldlinien 17 bei eingeschaltetem Elektromagneten 1 sind in den Fig. 2 bis 4 dargestellt. Der Magnetfelddetektor ist dabei von oben betrachtet.

Steht dem magnetfeldabhängigen Widerstand 6, wie in Fig. 2 gezeigt, eine Lücke 16 gegenüber, so treten die vom Elektromagneten 1 erzeugten und vom Kern 4 ausgehenden magnetischen Feldlinien 17 senkrecht in Richtung des Magnetfeldes $H_H$ durch den magnetfeldabhängigen Widerstand 6. Dessen Widerstand ändert sich weder bei diesem Magnetfeld noch bei nicht vorhandenem Magnetfeld.

Tritt nun gemäß Fig. 3 dem magnetfeldabhängigen Widerstand 6 eine Kante 18 gegenüber, so wird die Richtung der magnetischen Feldlinien 17 geändert; es tritt ein Querfeld $H_Q$ auf. Durch dieses Querfeld $H_Q$ wird der Widerstand des magnetfeldabhängigen Widerstands verändert, in der Regel vermindert. Wird in dieser Stellung der Kante 18 der Elektromagnet 1 abgeschaltet, so verschwindet sein Magnetfeld und damit auch das Querfeld $H_Q$. Dadurch stellt sich am magnetfeldabhängigen Widerstand 6 der ursprüngliche Widerstandswert wieder ein. Steht nun dem magnetfeldabhängigen Widerstand 6 ein Zahn 15 gegenüber, wie in Fig. 4 dargestellt, so treten alle magnetischen Feldlinien 17 wieder senkrecht durch den magnetfeldabhängigen Widerstand 6. Es tritt kein Querfeld $H_Q$ auf und der Widerstandswert ändert sich nicht.

Durch Anwendung eines Wechselmagnetfeldes kann mit dem vorgeschlagenen Magnetfelddetektor die Bewegung oder die Position einer Kante 18 oder die Vorbeibewegung eines Zahnes 15 oder einer Lücke 16 eines ferromagnetischen Teils 14 erkannt werden. Dabei ist die Frequenz des Magnetfeldes höher, insbesondere um ein Vielfaches höher, zu wählen als die maximale Änderung des Magnetfeldes durch ein ferromagnetisches Teil 14. Hierdurch kann man bei einer bestimmten Magnetfeldänderung beispielsweise ein Impulsdiagramm gemäß Fig. 3a erhalten, wenn sich z.B. ein ferromagnetisches Zahnrad am magnetfeldabhängigen Widerstand 6 vorbeibewegt. Der erfindungsgemäße Magnetfelddetektor eignet sich daher besonders für die Erkennung langsamer oder stehender Vorgänge.

Anstelle der Verwendung eines Elektromagneten 1 zur Erzeugung des Wechselmagnetfeldes kann auch ein permanent magnetisiertes Polrad 19 oder ein mit Permanentmagneten versehenes Polrad 19 oder ein Stabmagnet Verwendung finden, deren Drehachse 20 senkrecht zur Längsrichtung 21 des magnetfeldabhängigen Widerstandes 6 angeordnet ist. Die Magnetpole sind am Polrad 19 so angebracht, daß bei Vorbeidrehen derselben am magnetfeldabhängigen Widerstand 6 kein Querfeld $H_Q$ auftritt, also auch keine Widerstandsänderung bewirkt wird. Die Polfläche 22 eines Magnetpoles 23 und die Lücken 24 entsprechen dabei in ihren Abmessungen wenigstens annähernd der Fläche des magnetfeldabhängigen Widerstandes 6. Da hier kein Zeittakt wie beim Ein- und Ausschalten eines Elektromagneten 1 zur Verfügung steht, wird hier ein Synchronisationssignal erforderlich. Dies kann beispielsweise durch einen querliegenden zweiten magnetfeldabhängigen Widerstand 25 erzeugt werden, dessen Widerstandswert sich jeweils beim Vorbeibewegen eines Pols 23 ändert.

Das durch das Wechselmagnetfeld bei Änderung der Feldrichtung auftretende Signal ist mit verschiedenen Meßverfahren meßbar. Anhand der nachfolgend beschriebenen Schaltungsbeispiele sind zwei Meßverfahren erläutert.

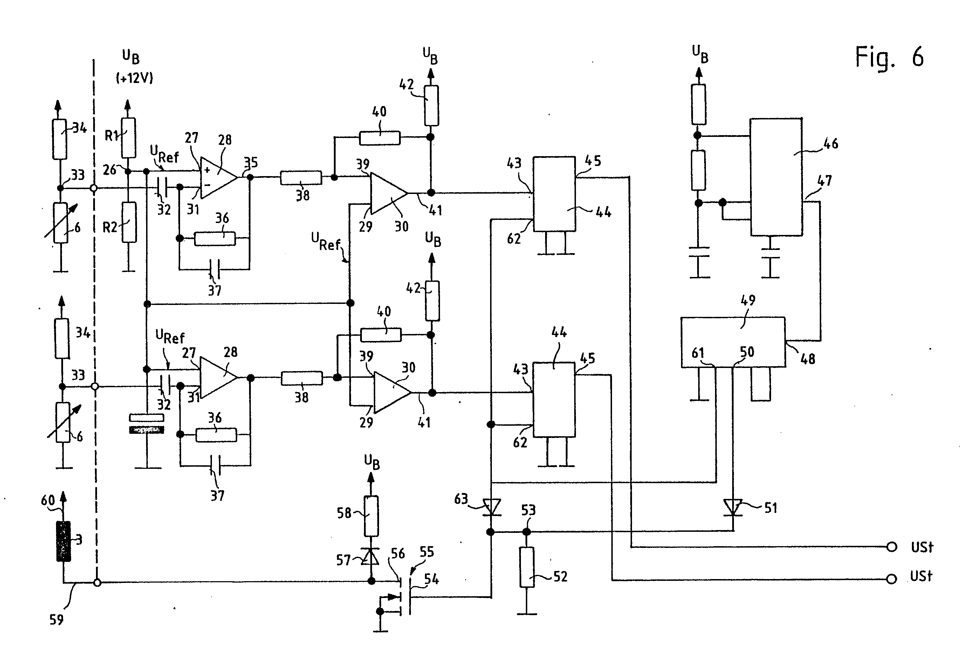

In Fig. 6 ist eine Schaltungsanordnung dargestellt, mit der die Erzeugung eines Steuersignals USt möglich ist. Bei dieser wird eine Referenzspannung mit der am magnetfeldabhängigen Widerstand 6 abgreifbaren und verstärkten Spannung immer dann verglichen, wenn der Elektromagnet eingeschaltet ist. Das erhaltene Signal wird dann einem Speicher-Schaltkreis zugeführt, und im Takt des Elektromagneten, jedoch verzögert, eingelesen und ausgegeben.

Zur Erzeugung einer Referenzspannung $U_{Ref}$ dient ein Spannungsteiler aus den Widerständen R1 und R2. Der Teilerpunkt 26 ist am positiven Eingang 27 eines als Differenzverstärker arbeitenden ersten Operationsverstärkers 28, und am negativen Eingang 29 eines als Komparator betriebenen zweiten Operationsverstärkers 30 angeschlossen. Am negativen Eingang 31 des ersten Operationsverstärkers 28 ist über einen Kondensator 32 der Teilerpunkt 33 eines Spannungsteilers aus einem ohm'schen Widerstand 34 und dem magnetfeldabhängigen Widerstand 6 angeschlossen. Der Ausgang 35 des ersten Operationsverstärkers 28 ist über einen Rückkopplungswiderstand 36 und einen parallel zu diesem liegenden Rückkopplungskondensator 37 am negativen Eingang 31 des ersten Operationsverstärkers 28 angeschlossen. Die Kapazitätswerte der beiden Kondensatoren 32 und 37 bestimmten hierbei den Verstärkungsfaktor des ersten Operationsverstärkers 28. Beispielsweise besitzt der Kondensator 32 einen Wert von 1μF und

der Rückkopplungskondensator 37 einen Wert von 1 nF. Der Verstärkungsfaktor beträgt damit 1000.

Der Ausgang 35 des ersten Operationsverstärkers 28 liegt über einen Widerstand 38 am positiven Eingang 39 des zweiten Operationsverstärkers 30, der außerdem über einen Rückkopplungswiderstand 40 am Ausgang 41 des zweiten Operationsverstärkers 30 liegt. Zusätzlich ist der Ausgang 41 über einen Vorwiderstand 42 an Betriebsspannung $U_B$ und an dem Eingang 43 eines Speicher-Schaltkreises 44, z.B. eines D-Flip-Flops, angeschlossen. Für den Speicherschaltkreis 44 eignet sich besonders die unter der Bezeichnung 4013 bekannte integrierte Schaltung. Der Ausgang 45 des Speicher-Schaltkreises 44 liefert das gewünschte Steuersignal in Form eines Rechteckimpulsdagramms.

Desweiteren besitzt die Schaltung einen Taktgenerator 46, z.B. einen Timer mit dem Timer-Baustein 555, der eine bestimmte Taktfrequenz f liefert. Diese beträgt zweckmäßigerweise etwa 50 bis 20000 Hz, vorzugsweise 300 bis 3000 Hz. Der Taktausgang 47 des Taktgenerators 46 liegt am clock-Eingang 48 eines Zählers 49, beispielsweise dem integrierten Schaltungsbaustein 4017. Letzterer ist so geschaltet, daß er jeweils immer vier Stufen, nämlich von 0 bs 3 zählt. Der den ersten Impuls liefernde Ausgang 50 ist über eine Diode 51 und einen Widerstand 52 an Masse geschaltet. Der Verbindungspunkt 53 zwischen Diode 51 und Widerstand 52 liegt am Steuereingang 54 eines Schalttransistors 55, z.B. dem Gate eines Feldeffekttransistors. Die eine Elektrode 56 des letzteren liegt über eine Freilaufdiode 57 und einem Vorwiderstand 58 an Betriebsspannung $U_B$ und außerdem am kalten Ende 59 der Wicklung 3 des Elektromagneten 1. Das heiße Ende 60 der Wicklung 3 liegt an Betriebsspannung $U_B$.

Der den Folgeimpuls liefernde Ausgang 61 des Zählers 49 liegt am Takteingang 62 des Speicher-Schaltkreises 44 und über eine Entkopplungsdiode 63 am Verbindungspunkt 53 der Diode 51 und des Widerstandes 52.

Die Wirkungsweise dieser Schaltung ist folgende:

Wird die Gesamtschaltung an Betriebsspannung $U_B$ gelegt, so entsteht am Verbindungspunkt 26 von R1 und R2 die Referenzspannung $U_{Ref}$. Diese stellt sich durch Nachregelung des ersten Operationsverstärkers 28 auch an dessen Ausgang 35 ein. Damit liegt an beiden Eingängen 29 und 42 des zweiten Operationsverstärkers 30 ebenfalls die Referenzspannung $U_{Ref}$ und das Ausgangssignal desselben liegt auf Null. Demzufolge liegt am Eingang 43 des Speicher-Schaltkreises 44 das Potential auf low-Pegel.

Gleichzeitig beginnt der Taktgenerator 46 mit der Erzeugung der Taktfrequenz f mit der Periodendauer T. Der erste vom Zähler 49 bereitgestellte Impuls am Ausgang 50 steuert den Schalttransistor 55 auf. Dadurch liegt das kalte Ende 59 der Wicklung 3 an Masse und die Wicklung 3 liegt an Betriebsspannung $U_B$. Der Kern 4 des Elektromagneten 1 ist daher magnetisiert und sein Feld durchsetzt den magnetfeldabhängigen Widerstand 6 in der zuvor beschriebenen Weise senkrecht zu seiner Flächenausdehnung. Es sei angenommen, daß kein ferromagnetisches Teil 14 so angebracht ist, daß die Richtung der magnetischen Feldlinien 17 verändert wird. Dementsprechend tritt am Teilerpunkt 33 keine Potentialänderung auf, am Ausgang 35 des ersten Operationsverstärkers 28 bleibt $U_{Ref}$ erhalten und der Ausgang 41 des zweiten Operationsverstärkers 30 bleibt auf low-Pegel.

Mit dem folgenden vom Ausgang 61 des Zählers 49 gelieferten Impuls wird über den Takteingang 62 der Speicher-Schaltkreis 44 angesteuert und der low-Pegel des Eingangs 43 auf den Ausgang 45 übertragen. Es sei angenommen, daß auch hier der low-Pegel auftritt, also der Ausgang Q gewählt wurde. Zugleich steuert der zweite Impuls den Schalttransistor 55 weiterhin in Durchlaßrichtung, so daß der Elektromagnet 1 über die Wicklung 3 eingeschaltet bleibt.

Beim nachfolgenden dritten und vierten Impuls des Zählers 49 wird die Wicklung 3 des Elektromagneten 1 abgeschaltet, der low-Pegel am Ausgang 45 des Speicher-Schaltkreises 44 bleibt daher erhalten. An diesem Zustand ändert sich auch dann nichts, wenn sich das Potential am Teilerpunkt 33 z.B. infolge Temperaturdrift oder Alterung etc. langsam ändert. Kommt jedoch das ferromagnetische Teil 14 mit seiner Kante 18 in den Bereich des magnetfeldabhängigen Widerstandes 6, so wird ein anstehendes Wechselmagnetfeld verzerrt und es kann ein Querfeld $H_Q$ auftreten.

Sobald ein Querfeld $H_Q$ auftreten kann (Magnetfeld und Kante 18 vorhanden), wird beim ersten Impuls des Zählers 49 die Wicklung 3 des Elektromagneten 1 angeschaltet und das Magnetfeld erzeugt. Zugleich wird durch das Querfeld $H_Q$ der Widerstandswert des magnetfeldabhängigen Widerstandes gegenüber seinem vorherigen Wert verändert, in der Regel verringert. Dadurch entsteht bei einer Verringerung des magnetfeldabhängigen Widerstandes 6 am Kondensator 32 -wenn ein Magnetfeld vorhanden ist- ein negativer Impuls, der am Ausgang 35 des ersten Operationsverstärkers 28 zu einem um den Verstärkungsfaktor vergrößerten positiven Impuls führt. Hierdurch wird der als Komparator geschaltete zweite Operationsverstärker 30 voll durchgesteuert, sein Ausgang liegt jetzt auf high-Pegel. Dadurch liegt jetzt der Pegel am Eingang 43 des Speicher-Schaltkreises 44 ebenfalls auf high-Pegel. Mit dem zweiten Impuls des Zählers 49 wird dieser high-Pegel auf den Ausgang des Speicher-Schaltkreises 44 übertragen, der den Pegel als Steuersignal USt ausgibt.

Beim nachträglichen Abschalten der Wicklung 3 infolge fehlender Ansteuerimpulse des Zählers 49 geht das Potential am Teilerpunkt 33 wieder hoch. Am Kondensator 32 entsteht also ein positiver Impuls, der am Ausgang 35 des ersten Operationsverstärkers 28 als verstärkter negativer Impuls auftritt. Dies hat zur Folge, das der Ausgang des zweiten Operationsverstärkers 30 auf Null zurückgeht. Damit ist der Schaltzustand wie am Anfang beim Einschalten der Schaltung nahezu wieder hergestellt. Der Unterschied besteht darin, daß am Ausgang 45 des Speicher-Schaltkreises 44 das Steuersignal USt als high-Pegel ansteht. Diese Schaltvorgänge wiederholen sich, solange das ferromagnetische Teil 14 in einer die Feldlinienrichtung ändernden Weise angeordnet ist. Ist dies nicht mehr der Fall, so kehrt der Pegel des Ausgangs 45, d.h. das Steuersignal USt, in der vorher beschriebenen Weise auf low-Pegel zurück.

Durch diese Maßnahme ist also eine eindeutige Erkennung der Lage des ferromagnetischen Teils 14 möglich. Änderungen des Widerstandswertes des magnetfeldabhängigen Widerstandes durch Alterung, Temperatur, mechanische Spannungen oder andere Faktoren haben dabei keinen Einfluß auf das Ergebnis.

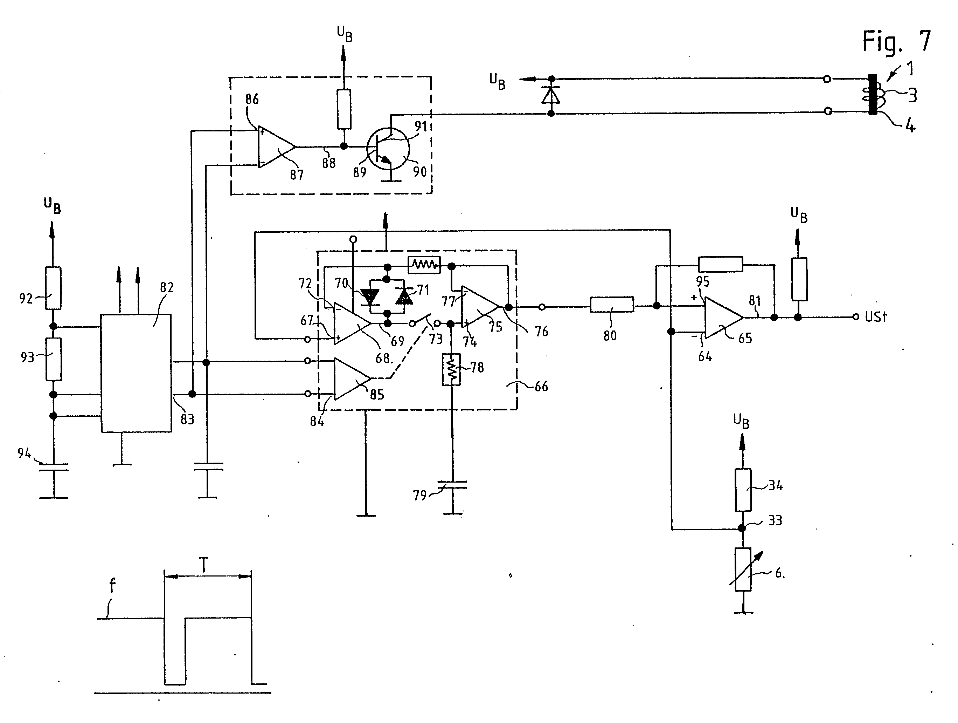

Gemäß einem anderen Verfahren wird die bei vorhandenem oder nicht vorhandenem Querfeld am magnetfeldabhängigen Widerstand 6 abgegriffene Spannung unmittelbar durch einen Komparator verglichen. Dies geschieht so, daß die Spannung am magnetfeldabhängigen Widerstand 6 zum einen direkt an den einen Eingang und über einen Speicher-Schaltkreis auf den anderen Eingang des Komparators geschaltet ist und der am Speicher-Schaltkreis anstehende Wert über einen Taktgenerator synchron mit der Ein- und Ausschaltung des Elektromagneten 1 zum Komparator übertragen wird. Eine hierfür geeignete Schaltung zeigt die Fig. 7, die nachfolgend beschrieben ist.

Der Teilerpunkt 33 des Spannungsteilers aus ohm'schem Widerstand 34 und magnetfeldabhängigem Widerstand 6 ist direkt an dem negativen Eingang 64 eines Impulsformers 65 angeschlossen. Letzterer ist vorzugsweise ein Schmitt-Trigger und besteht zweckmäßigerweise aus einem Operationsverstärker. Außerdem liegt der Teilerpunkt 33 an einem Speicher-Schaltkreis 66, und zwar am positiven Eingang 67 eines ersten Operationsverstärkers 68, dessen Ausgang 69 über zwei antiparallel geschaltete Dioden 70, 71 auf seinen negativen Eingang 72 rückgekoppelt ist. Der Operationsverstärker 68 wirkt also als Spannungsfolger.

Der Ausgang 69 des Operationsverstärkers 68 ist über einen Schalter 73, der hier als elektronisch ansteuerbarer Schaltkreis ausgebildet ist, mit dem positiven Eingang 74 eines zweiten als Spannungsfolger geschalteten Operationsverstärkers 75 verbunden. Der Ausgang 76 des letzteren ist daher direkt mit seinem negativen Eingang 77 verbunden. Außerdem ist der positive Eingang 74 des zweiten Operationsverstärkers 75 über einen internen Widerstand 78 und einen externen hold-Kondensator 79 nach Masse geschaltet. Der Ausgang 76 des zweiten Operationsverstärkers 75 liegt über einen Widerstand 80 am positiven Eingang des Impulsformers 65. Dessen Ausgang 81 liefert das Steuersignal USt.

Die Schaltung enthält weiter einen Taktgenerator 82, z.B. den integrierten Schaltkreis Typ 555. Dessen die Taktfrequenz f mit der Periodendauer T liefernder Ausgang 83 liegt an einem Eingang 84 eines dritten Operationsverstärkers 85 des Speicher-Schaltkreises 66, der den Schalter 73 ein- und ausschalten kann, wie weiter unten noch beschrieben ist. Der Ausgang 83 liegt außerdem am positiven Eingang 86 eines als Komparator geschalteten Operationsverstärkers 87, dessen Ausgang 88 an der Basis 89 eines beispielsweise in Ermitterschaltung betriebenen Schalttransistors 90 liegt. Der Kollektor 91 des Schalttransistors 90 liegt über die Wicklung 3 des Elektromagneten 1 an der Betriebsspannung $U_B$. Die Widerstände 92 und 93 und der Kondensator 94 bestimmen die Taktfrequenz f mit der Periodendauer T des Taktgenerators 82.

Die Wirkungsweise dieser Schaltung ist folgende:

Es sei angenommen, daß die Schaltungsanordnung mit $U_B$ verbunden ist und der Taktgenerator 82 gerade low-Pegel liefere. Außerdem sei kein die Richtung der Feldlinien 17 änderndes ferromagnetisches Teil 14 im Bereich des magnetfeldabhängigen Widerstandes 6 vorhanden. In diesem Schaltzustand liefert der Operationsverstärker 87 eine negative Ausgangsspannung und der Schalttransistor 90 ist gesperrt. Infolgedessen ist die Wicklung 3 des Elektromagneten 1 ohne Strom und der Elektromagnet 1 daher ausgeschaltet. Gleichzeitig wird durch den Low-Pegel der Schalter 73 über den dritten Operationsverstärker 85 eingeschaltet. Dadurch wird das am Teilerpunkt 33 vorhandene Potential über die beiden als Spannungsfolger geschalteten Operationsverstärker 68 und 75 auf den positiven Eingang 95 des Impulsformers 65 übertragen. Da an dessen negativem Eingang 64 das gleiche Potential anliegt, ist der Ausgang desselben auf low-Pegel. Tritt jetzt der high-Pegel der Taktfrequenz f des Taktgenerators 82 am positiven Eingang 86 des Operationsverstärkers 87 auf, so springt dessen Ausgang 88 ebenfalls auf high und der Schalttransistor 90 wird durchgeschaltet. Infolgedessen ist der Elektromagnet 1 eingeschaltet. Zugleich wird über den dritten Operationsverstärker 85 des Speicher-Schaltkreises 66 der Schalter 73 geöffnet. Durch die am hold-Kondensator 79 gespeicherte Ladung bleibt der Ausgang 76 des zweiten Operationsverstärkers 75 auf dem vorher durchgeschalteten Potential.

Da, wie angenommen, der Widerstandswert des magnetfeldabhängigen Widerstandes 6 nicht durch ein ferromagnetisches Teil 14 verändert wird, bleibt die Spannungsdifferenz am Eingang des Impulsformers 65 Null und dessen Ausgang daher auf low-Potential. Wie ersichtlich, hat das Ein- und Ausschalten des Elektromagneten 1 in diesem Fall keinen Einfluß auf die Größe des Steuersignals USt. Weiterhin wirkt sich auch eine beispielsweise temperaturbedingte Änderung oder eine Alterung des magnetfeldabhängigen Widerstandes nicht aus, da in diesem Fall an den Eingängen 64 und 95 des Impulsformers 65 trotzdem die Spannungsdifferenz Null bleibt.

Gelangt jedoch ein ferromagnetisches Teil 14 derart in den Bereich des magnetfeldabhängigen Widerstandes 6, daß die Richtung der Feldlinien 17 geändert wird, d.h. ein Querfeld $H_Q$ auftritt, so entsteht bei eingeschaltetem Elektromagneten 1 am Ausgang des Impulsformers 65 ein high-Pegel. In diesem Fall wird nämlich bei einem low-Pegel am Ausgang 83 des Taktgenerators 82 und bei ausgeschaltetem Elektromagneten 1 das vorher vorhandene Potential am Teilerpunkt 33 über die Operationsverstärker 68 und 75 an den positiven Eingang 95 des Impulsformers 65 gelegt und bleibt dort, wie oben beschrieben, auch während des high-Pegels am Ausgang 83 bestehen. Bei Anliegen des high-Pegels am positiven Eingang 86 des Operationsverstärkers 87 wird der Elektromagnet 1 wieder eingeschaltet. Da jetzt ein Querfeld $H_Q$ vorhanden ist, wird der Widerstandswert des magnetfeldabhängigen Widerstandes 6 vermindert. An den Eingängen 95 und 64 des Impulsformers 65 entsteht also eine negative Spannungsdifferenz, so daß der Ausgang 81 des Impulsformers 65 auf high-Pegel springt. Wird beim nächsten low-Pegel des Ausgangs 83 der Elektromagnet 1 abgeschaltet, so wird an den Eingängen 95 und 64 des Impulsformers die Spannungsdifferenz wieder Null, so daß auch dessen Ausgang 81 wieder auf low-Pegel schaltet. Man erhält also in diesem Fall als Steuersignal ein Impulsdiagramm der Taktfrequenz f mit der Periodendauer T.

Wie ersichtlich, sind auch in diesem Fall Widerstandsänderungen des magnetfeldabhängigen Widerstandes 6, die auf Temperatur oder Alterung oder sonstige gegenüber der Taktfrequenz f langzeitig auftretenden Einflüssen herrühren, ohne Wirkung auf das Steuersignal USt.

Die Erfindung ist auch vorteilhaft anwendbar bei Verwendung mehrerer, beispielsweise in Brückenschaltung angeordneter magnetfeldabhängiger Widerstände 6.

## Ansprüche

1. Magnetfelddetektor mit einem Magnetfeldsensor, der aus wenigstens einem magnetfeldabhängigen Widerstand und einem diesem zugeordneten Magneten besteht, in dessen Feld der magnetfeldabhängige Widerstand in der Weise angeordnet ist, daß nur eine Querkomponente des Feldes eine Widerstandsänderung des magnetfeldabhängigen Widerstandes verursacht, **dadurch gekennzeichnet**, daß ein, ein Wechselmagnetfeld erzeugender Magnet (1, 9) vorgesehen ist.

2. Magnetfelddetektor nach Anspruch 1, dadurch gekennzeichnet, daß zur Erzeugung des Wechselmagnetfeldes ein Elektromagnet (1) vorgesehen ist.

3. Magnetfelddetektor nach Anspruch 2, dadurch gekennzeichnet, daß die Frequenz des Wechselmagnetfeldes 50 bis 20.000 Hz beträgt.

4. Magnetfelddetektor nach Anspruch 1, dadurch gekennzeichnet, daß zur Erzeugung des Wechselmagnetfeldes ein permanentmagnetisches drehbar gelagertes Polrad (19) vorgesehen ist, dessen Pole (23) am magnetfeldabhängigen Widerstand (6) derart vorbeibewegbar sind, daß ohne Einwirkung eines ferromagnetischen Teils der Widerstand des magnetfeldabhängigen Widerstandes (6) konstant bleibt.

5. Magnetfelddetektor nach Anspruch 4, dadurch gekennzeichnet, daß die Drehachse (20) des Polrades (19) senkrecht zur Längsrichtung (21) des magnetfeldabhängigen Widerstandes (6) angeordnet ist.

6. Verfahren zur Erzeugung eines elektrischen Signals unter Verwendung des Magnetfelddetektors nach einem der Ansprüche 1 bis 5, dadurch gekennzeichnet, daß der Widerstand des magnetfeldabhängigen Widerstandes (6) oder eine an ihm abgreifbare Spannung abwechselnd im nicht vom Magnetfeld und im vom Magnetfeld durchsetzten Zustand gemessen wird, der aus letzterer Messung erhaltene Meßwert mit einem Referenzwert ($U_{Ref}$) verglichen wird und entweder der Vergleichswert als Steuersignal verwendet oder aus diesem ein Steuersignal (USt) gebildet wird.

7. Verfahren nach Anspruch 6, dadurch gekennzeichnet, daß als Referenzwert der am magnetfeldabhängigen Widerstand (6) anstehende Meßwert bei nicht vom Magnetfeld durchsetztem magnetfeldabhängigen Widerstand (6) verwendet wird.

8. Verfahren nach Anspruch 6, dadurch gekennzeichnet, daß als Referenzwert der am magnetfeldabhängigen Widerstand (6) anstehende Meßwert bei vom Magnetfeld durchsetztem magnetfeldabhängigen Widerstand (6) verwendet wird.

9. Verfahren nach einem der Ansprüche 6 bis 8, dadurch gekennzeichnet, daß der Meßwert vom magnetfeldabhängigen Widerstand (6) in dem Zustand, in dem das Magnetfeld des Elektromagneten (1) oder des Polrades (19) den magnetfeldabhängigen Widerstand (6) durchsetzt und nach Vergleich mit einem Referenzwert ($U_{Ref}$) einem Meßspeicher (44) zugeführt wird, der je nach Änderung oder Konstanz des Meßwertes ein unterschiedliches Steuersignal (USt) ausgibt.

10. Verfahren nach einem der Ansprüche 6 bis 8, dadurch gekennzeichnet, daß das am magnetfeldabhängigen Widerstand (6) auftretende Potential sowohl als Referenzwert ($U_{Ref}$) als auch als Meßwert verwendet wird, indem das Potential über einen Meßwertspeicher (Speicher-Schaltkreis 66) an den einen Eingang (95) eines Impulsformers (65) und direkt an den anderen Eingang (64) des Impulsformers (65) geleitet wird, und daß ein Taktgenerator (82) vorhanden ist, der eine Taktfrequenz (f) mit low- und high-Pegel ausgibt, wobei bei low-(high-)-Pegel der am Meßwertspeicher (Speicherschaltkreis 66) anstehende Wert eingelesen wird und während dieser Zeit der Elektromagnet (1) durch den gleichen low-(high-)-Pegel ausgeschaltet wird und bei high-(low-)-Pegel ein Schalter (73) geöffnet und der Elektromagnet (1) eingeschaltet wird.

11. Schaltungsanordnung zur Durchführung des Verfahrens nach Anspruch 9, dadurch gekennzeichnet, daß sie einen Differenzverstärker (28), insbesondere einen Operationsverstärker, aufweist, an dessen ersten Eingang (27) eine Referenzspannung ($U_{ref}$) angeschlossen ist und dessen zweiter Eingang (31) über einen Kondensator (32) mit dem Teilerpunkt (33) eines ohm'schen Spannungsteilers (34, 6), von dem der eine Widerstand der magnetfeldabhängige Widerstand (6) ist, verbunden ist, daß der Ausgang (35) des Differenzverstärkers (28) über einen Rückkopplungswiderstand (36) und einen zu diesem parallel geschalteten Rückkopplungskondensator (37) an den zweiten Eingang (31) angeschlossen ist, daß der Ausgang (35) des Differenzverstärkers (28) über einen Widerstand (38) mit dem ersten Eingang (39) eines Komparators (30) verbunden ist, an dessen zweiten Eingang (29) die Referenzspannung ($U_{Ref}$) anliegt und der von seinem Ausgang (41) zu seinem ersten Eingang (39) über einen Widerstand (40) rückgekoppelt ist und dessen Ausgang (41) am Eingang (43) eines Speicher-Schaltkreises (44) angeschlossen ist, der das Steuersignal (USt) liefert, und daß ferner ein Taktgenerator (46) vorhanden ist, dessen Ausgang (47) am Eingang (48) eines Zählers (49) liegt, daß derjenige Ausgang (50) des Zählers (49), der einen ersten Impuls liefert, über eine Diode (51) unmittelbar oder mittelbar über ein Schaltglied (Schalttransistor 55) an der Wicklung (3) des Elektromagneten (1) angeschlossen ist und daß derjenige Ausgang (61) des Zählers (49), der einen nachfolgenden Impuls liefert, am Takteingang (62) des Speicher-Schaltkreises (44) angeschlossen ist und außerdem über eine Entkopplungsdiode (63) mit der Wicklung (3) des Elektromagneten (1) unmittelbar oder über das Schaltglied (Schalttransistor 55) mittelbar verbunden ist.

12. Schaltungsanordnung zur Durchführung des Verfahrens nach Anspruch 10, dadurch gekennzeichnet, daß der Teilerpunkt (33) eines Spannungsteilers (34, 6), von dem der eine Widerstand der magnetfeldabhängige Widerstand (6) ist, an den einen Eingang (67) eines als Spannungsfolger geschalteten ersten Operationsverstärkers (68) angeschlossen ist, dessen Ausgang (69) über einen Schalter (73) am einen Eingang (74) eines ebenfalls als Spannungsfolger geschalteten zweiten Operationsverstärkers (75) angeschlossen ist und dieser Eingang (74) über einen hold-Kondensator (79) nach Masse verbunden ist, daß der Ausgang (76) des zweiten Operationsverstärkers (75) über einen Widerstand (80) mit dem einen Eingang (95) eines Impulsformers (65) verbunden ist, an dessen anderen Eingang (64) der Teilerpunkt (33) des Spannungsteilers (34, 6) angeschlossen ist, daß die Schaltung ferner einen Taktgenerator (82) besitzt, dessen Impulsausgang (83) über einen elektronischen Schalter (Schalttransistor 90) den Elektromagneten (1) und über eine elektronische Steuereinrichtung (85) den Schalter (73) ansteuert.

Fig. 2

Fig. 3

Fig.1

Fig. 3a.

Fig. 4

Fig. 5

$R(u)$

$t$

$H_H$

$H_a$

$H_H$

$H_H$

Blatt

Fig. 6

Fig. 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | PATENT ABSTRACTS OF JAPAN, Band 9, Nr. 86 (P-349)[1809], 16. April 1985; & JP-A-59 214 784 (CANON K.K.) 04-12-1984 * Insgesamt * --- | 1,2 | G 01 R 33/06 |
| Y | PATENT ABSTRACTS OF JAPAN, Band 8, Nr. 175 (P-294)[1612], 11. August 1984; & JP-A-59 70 978 (MATSUSHITA DENKI SANGYO K.K.) 21-04-1984 * Insgesamt * --- | 1,2 | |
| A | DE-A-3 426 784 (ROBERT BOSCH GmbH) * Ansprüche 1,2; Figuren 2,9 * ----- | 1,4 | |

RECHERCHIERTE SACHGEBIETE (Int. Cl.4)

G 01 R
G 01 V

Der vorliegende Recherchenbericht wurde für alle Patentansprüche erstellt

| Recherchenort | Abschlußdatum der Recherche | Prüfer |
|---|---|---|
| DEN HAAG | 20-03-1989 | SWARTJES H.M. |